# EUROPEAN PATENT APPLICATION

(11) **EP 3 944 499 A1**
(43) Date of publication of application: **26.01.2022**
(21) Application number: 20187372.6
(22) Date of filing: 23.07.2020
(51) Int. Cl.: H03K 17/082, H03K 17/06, H03K 17/687

(54) **PRE-HEATER RELAY**

(71) Applicant: HIDRIA d.o.o., 1000 Ljubljana (SI)
(72) Inventor: KLEC, Jaka, 5220 TOLMIN (SI); DOBRAVEC, Klemen, 5222 KOBARID (SI); DOLENC, Igor, 5220 TOLMIN (SI)
(74) Representative: BARRE LAFORGUE

(57) **Abstract**

There is disclosed a relay (100) comprising a high stage (HS), a low stage (LS), an intermediate stage (IS), and a microcontroller (U4). The relay is configured to be connected between a voltage source (110) and a pre-heater (120) to be driven.

## Description

### [Technical Field]

The invention relates generally to power electronics and more particularly to pre-heater relays of the kind used in automobile or truck vehicles.

### [Background Art]

Following the obsolescence of one of its main components, the high current Smart MOSFET, the inventors developed a new design for a pre-heater relay. The new design gave the opportunity to optimize pre-existing features and to introduce new features, such as safety features.

### [Summary of Invention]

The present invention aims to provide a relay configured to be connected between a voltage source and a pre-heater to be driven, as described in the accompanying claims.

Specific embodiments of the invention are set forth in the dependent claims.

These and other aspects of the invention will be apparent from and elucidated with reference to the embodiments described hereinafter.

### [Brief Description of Drawings]

Other features, details and advantages of the invention will become more apparent from the detailed illustrating description hereafter regarding the drawings on which:
[Fig. 1]: figure 1 is a general diagram which serves to illustrate the context of the invention,
[Fig. 2]: figure 2 is a general diagram which serves to illustrate a relay according to an embodiment of the invention,
[Fig. 3]: figure 3 is a general diagram which serves to illustrate a current measurement means according to an embodiment of the invention,
[Fig. 4]: figure 4 is a general diagram which serves to illustrate a charge pump according to an embodiment of the invention.
[Fig. 5]: figure 5 is an embodiment of the charge pump of figure 4.

### [Description of Embodiments]

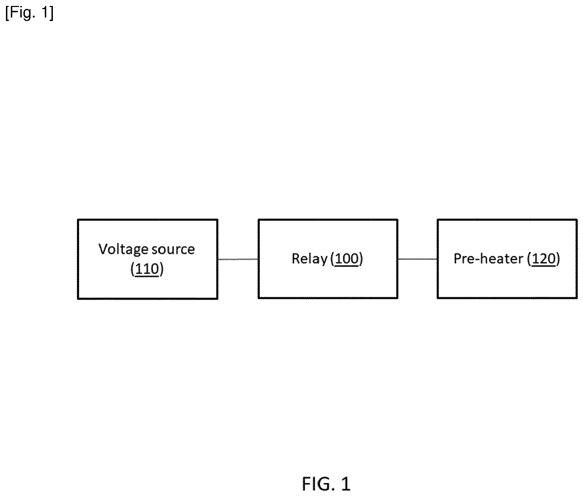

Figure 1 illustrates a relay 100 which is configured to be connected between a voltage source 110, and a load 120.

In the exemplary embodiment shown in the figures, the voltage source 110 is a battery voltage, and the load 120 is a pre-heater.

In order to drive the load 120, the relay 100 comprises, in a known way, a high stage HS and a low stage LS, which are connected in series.

In particular, the high stage HS comprises a plurality of parallel MOSFETs (hereinafter called "high MOSFET") TR11, TR12 and the low stage LS comprises a plurality of parallel MOSFETs (hereinafter called "low MOSFET") TR21, TR22.

In an example, the high MOSFETs TR11, TR12 and the low MOSFETs TR21, TR22 are N-channel MOSFETs.

One could safely consider using only one high and/or one low MOSFET. However, using two or more high and low MOSFETs would allow the reduction of the current per MOSFET and thus the reduction of the heating through the power component.

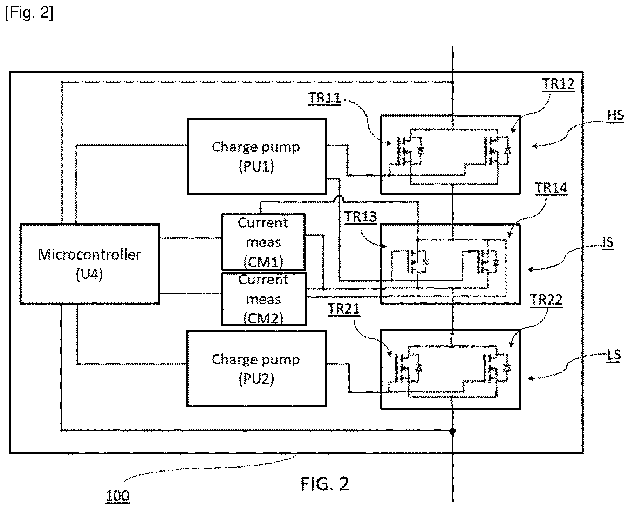

Furthermore, in the invention, as illustrated in figure 2, the relay 100 further comprises an intermediate stage IS, which is connected in series and is interspersed between the high stage HS and the low stage LS.

The intermediate stage IS comprises a plurality of parallel MOSFETs hereinafter called "intermediate MOSFET") TR13, TR14.

In an example, the intermediate MOSFETs TR13, TR14 are N-channel MOSFETs.

One could safely consider using only one intermediate MOSFET. However, using two or more intermediate MOSFETs would allow the reduction of the current per MOSFET and thus the reduction of the heating through the power component.

In figure 2, each of the high MOSFETs TR11, TR12 of the high stage HS is arranged as follows:
- its drain electrode is connected to the voltage source 110,
- its source is connected to the intermediate stage IS , and
- its gate electrode is connected to a first charge pump PU1, in order to be commuted.

Furthermore, the high MOSFETs TR11, TR12 of the high stage HS are paralleled in a first direction. In the example of figure 2, each of the high MOSFET TR11, TR12 comprises a body diode having a forward direction directed from the source electrode to the drain electrode.

The first charge pump PU1 is connected to a microcontroller U4 such as a microprocessor, a digital signal processor or similar digital logic and control circuit. The electronic microcontroller U4 is configured to provide a control signal to the first charge pump PU1 so as to switch the first charge pump PU1 between on and off states.

The first charge pump PU1 is configured to raise the voltage applied to the gate electrodes of the high MOSFETs TR11, TR12. In an embodiment, the first charge pump PU1 is configured to double the voltage applied to the gate electrodes of the high MOSFETs TR11, TR12.

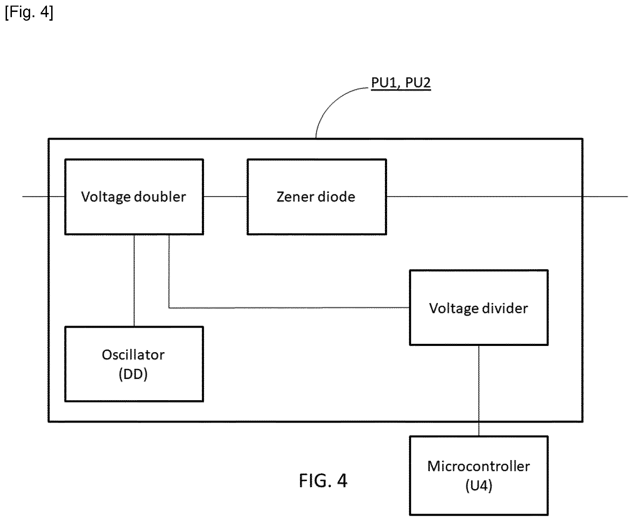

In an example, as illustrated in figure 4, the first charge pump PU1 may comprise a voltage doubler, an oscillator, a Zener diode and a voltage divider. The oscillator is connected to the voltage doubler and is configured to alternatively charge the capacitors of the doubler. The Zener diode is connected to the voltage doubler and is configured to clamp the output voltage of the voltage doubler to a predetermined threshold value so as to prevent overvoltage. Finally, the voltage divider is also connected to the voltage doubler to sense the voltage for microcontroller U4.

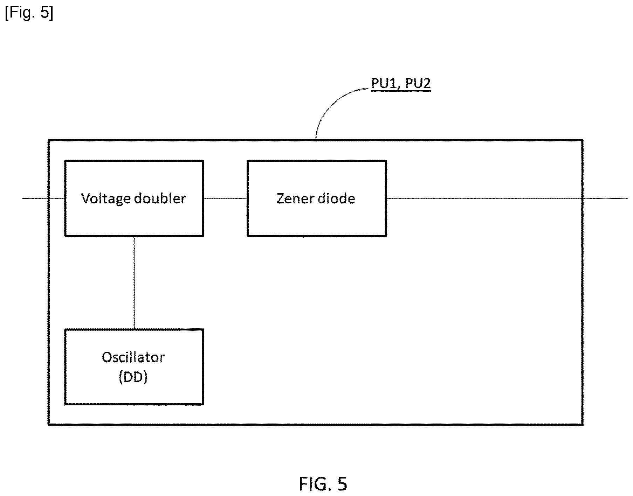

In another example, as illustrated in figure 5, the first charge pump PU1 of figure 4 does not comprise a voltage divider.

With these arrangements, the high stage HS allows a current to flow from the voltage source 110 to the intermediate stage IS, when commuted by the first charge pump PU1.

Also, in figure 2, each of the low MOSFETs TR21, TR22 of the low stage LS is arranged as follows:
- its drain electrode is connected to the intermediate stage IS,
- its source electrode is connected to the load 120, and
- its gate electrode is connected to a second charge pump PU2, in order to be commuted.

Furthermore, the low MOSFETs TR21, TR22 of the low stage LS are paralleled in the first direction. Indeed, in the example of figure 2, each low MOSFET TR21, TR22 comprises a body diode having a forward direction directed from the source electrode to the drain electrode.

The second charge pump PU2 is connected to the electronic microcontroller U4. The electronic microcontroller U4 is further configured to provide a control signal to the second charge pump PU2 so as to switch the second charge pump PU2 between on and off states.

The second charge pump PU2 is configured to raise the voltage applied to the gate electrodes of the low MOSFETs TR21, TR22. In an embodiment, the second charge pump PU2 is configured to double the voltage applied to the gate electrodes of the low MOSFETs TR21, TR22. In an example, as illustrated in figure 4, the second charge pump PU2 is arranged similarly to the first charge pump PU1.

With this arrangement, the low stage LS allows a current to flow from the intermediate stage IS to the load 120, when commuted by the second charge pump PU2.

Still, in figure 2, each of the intermediate MOSFETs TR13, TR14 of the intermediate stage IS is arranged as follows:
- its drain electrode is connected to the low stage LS,
- its source is connected to the high stage HS, and
- its gate electrode is connected to the first charge pump PU1.

Furthermore, the intermediate MOSFETs TR13, TR14 of the intermediate stage IS are paralleled in a second direction opposite to the first direction. In the example of figure 2, each intermediate MOSFET TR13, TR14 comprises a body diode having a forward direction directed from the source electrode to the drain electrode.

Hence, in other words, the MOSFETs of the low stage LS and the high stage HS are arranged in the first direction, while the MOSFETs of the intermediate stage IS are arranged in the second direction opposite to the first direction.

Still in figure 2, the first charge pump PU1 is configured to raise the voltage applied to the gate electrodes of the intermediate MOSFETs TR13, TR14. In an embodiment, the first charge pump PU1 is configured to double the voltage applied to the gate electrodes of the intermediate MOSFETs TR13, TR14.

With this arrangement, the intermediate stage IS allows a current to flow from the high stage HS to the low stage LS, when commuted by the first charge pump PU1.

Furthermore, the intermediate stage IS is also configured to provide at least two important functions to the relay 100.

In a first function, the intermediate stage IS may serve as a reverse polarity protector.

Indeed, when the power is connected with the normal polarity (i.e., with the voltage source 110 on top of the high stage HS, and the ground GND on bottom of the pre-heater 120, and the intermediate MOSFETs TR13, TR14 are switched on or off, the body diodes of intermediate MOSFETs TR13 and TR14 are arranged to allow a current to flow through the high stage HS and the low stage LS.

However, when, for any given reason, the power is connected with the reverse polarity, the body diodes of intermediate MOSFETs TR13 and TR14 are arranged to prevent current to flow through the high stage HS and the low stage LS, thereby immediately and permanently protecting the relay 100 and the load 120 from the effects of a reverse polarity.

In that case, the intermediate MOSFETs TR13, TR14 must not be switched on and must not be commuted (i.e., their gate electrode are not activated) so that the body diodes operate as intended. Accordingly, the microcontroller U4 generally does not activate the gate electrodes of the intermediate MOSFET TR13, TR14.

In a second function, the intermediate stage IS may serve as a monitoring arrangement of the current flowing through each of the high MOSFET TR11, TR12 and each of the low MOSFET TR21, TR22. In other words, current is measured on each MOSFET connected in parallel. Furthermore, current measurement is done simultaneously for both MOSFETs connected in parallel.

For instance, one can use the monitoring arrangement to detect a short-circuit to the ground, as detailed later.

In that case, the relay 100 further comprises at least one current measurement means CM1, CM2. However, as a safety precaution, the relay may comprise two current measurement means, that is one for each MOSFET connected in parallel.

Also, the microcontroller U4 is further connected to an input of the high stage HS and to an output of the low stage LS. The current measurement means CM1, CM2 are connected between the microcontroller U4 and the intermediate stage IS.

In particular, in figure 2, a first measurement means CM1 is arranged as follows:
- a first input pin is connected to the drain electrode of one intermediate MOSFET TR13, named left intermediate MOSFET, of the intermediate stage IS, and
- a second input pin is connected to the source electrode of the left intermediate MOSFET TR13 of the intermediate stage IS.

Still, in figure 2, a second measurement means CM2 is arranged as follows:
- a first input pin is connected to the drain electrode of one intermediate MOSFET TR14, named right intermediate MOSFET, of the intermediate stage IS, which is different from the left intermediate MOSFET TR13, and
- a second input pin is connected to the source electrode of the right intermediate MOSFET TR14 of the intermediate stage IS.

Furthermore, the current measurement means CM1, CM2 are configured to measure the current flowing through the intermediate stage IS, the measured current being indicative of the current originating from the high stage HS to the low stage LS.

In particular, the current measurement means CM1, CM2 are configured to measure the current flowing independently in each intermediate MOSFET TR13, TR14 which is representative of the current originating from a high MOSFET TR11, TR12 to a low MOSFET TR21, TR22.

In the known prior art, a current measurement is usually carried out by measuring a voltage drop over a shunt resistance. However, adding a shunt resistance in a relay 100 could be prejudicial. Indeed, a resistance generally adds heating and requires complexifying the thermal management which already handles highly heating power components such as MOSFETs.

According to an advantageous feature of the invention, the inventors decide to avoid using a resistance for carrying out current measurement.

Instead, the inventors decided to perform current measurement by measuring a voltage drop in an intermediate MOSFET TR13, TR14, between its drain electrodes and source electrodes. The equivalent resistance value of a MOSFET between its drain electrode and source RdsON is known when the MOSFET is activated or switched ON. Thus, a voltage drop measured between the drain electrode and the source electrode can be easily converted into a current by the microcontroller U4.

Therefore, with the invention, an intermediate MOSFET advantageously replaces a measuring shunt resistance, when it comes to voltage/current measurement, without the heating drawback.

As noted previously, the equivalent resistance value RdsON is known and exists only when the corresponding MOSFET is switched ON. Thus, the microcontroller U4 is configured to commute the corresponding MOSFET, by sending a control signal to its gate electrode through the first charge pump PU1, at least while carrying out the measurement.

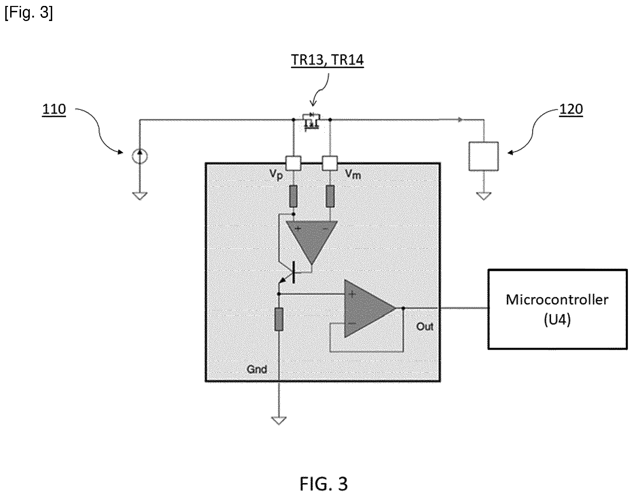

Hence, to measure the current flowing, each intermediate MOSFETs TR13, TR14 is associated to a current measurement means CM1, CM2, as seen on figure 3.

As detailed in figure 3, each current measurement means CM1, CM2 is configured for measuring a voltage between a drain electrode and a source electrode of an intermediate MOSFETs TR13, TR14 of the intermediate stage IS.

On figure 3, the measured voltage is taken between Vp pin and Vm pin.

As detailed in figure 3, each current measurement means CM1, CM2 measures the voltage between Vp pin, Vm pin, by means of an operational amplifier whose entries are connected such that the Vm pin is connected to the drain electrode of an intermediate MOSFET TR13, TR14 of the intermediate stage IS, while the Vp pin is connected to the source of the intermediate MOSFET TR13, TR14.

One can use the currents measured through the intermediate MOSFETs TR13, TR14 to monitor the proper functioning of the relay 100.

Indeed, the current measurements can be used to detect the occurrence of a short-circuit to ground so as to block the relay 100 before the occurrence of the short-circuit to ground damages the relay 100.

In order to detect the occurrence of such short-circuit to ground, the currents respectively produced by the current measurement devices CM1, CM2, are injected in a protection device such as a fuse, circuit breaker, relay, step-down transformer, and so on.

The protection device comprises a bipolar transistor commutation that draws both the gate electrodes of MOSFETs of the high stage HS and the low stage LS to the ground.

In particular, when gate electrodes of MOSFETs of the high stage HS and the low stage LS are drawn to ground by the bipolar transistor commutation, the bipolar transistor commutation respectively inhibits the commutation/activation lines of respectively high stage HS and low stage LS, thus letting respectively high MOSFETs or low MOSFETs switched off and thus inactivating the relay 100 and protecting it against the effects of the occurrence of a short-circuit to ground.

In an embodiment, the protection device may comprise a latch circuit.

Hence, when the occurrence of a short-circuit to ground has been detected, the detection signal is latched by the latch circuit, so as to maintain the de-activation of respectively high MOSFETs TR11, TR12 or low MOSFETs TR21, TR22 until a reset of the protection device.

Simulation and experiments confirm a short-circuit detection and blocking time of 10 µs, short enough to efficiently protect the relay 100.

In normal conditions, without the occurrence of a short-circuit to ground, the current is below a predetermined threshold value for short-circuit detection. The forgoing leads to such a voltage drop over each intermediate MOSFETs TR13, TR14, that the short-circuit protection is not triggered by current measurement means CM1 or current measurement means CM2.

In abnormal conditions, with the occurrence of a short-circuit to ground, the current rises very quickly over the predetermined threshold value for short-circuit detection. Accordingly, the voltage drop over each intermediate MOSFETs TR13, TR14 quickly raises above the threshold value thereby leading to the de-activation of respectively high MOSFETs TR11, TR12 or low MOSFETs TR21, TR22.

The inventors identified that the MOSFETs of the proposed design, mainly the high MOSFETs TR11, TR12 and the low MOSFETs TR21, TR22, may be subject to important currents.

Hence, according to an embodiment, the tracks connecting at least the high MOSFETs TR11, TR12 and the low MOSFETs TR21, TR22 are designed with the same lengths, and optionally with the same widths, to equilibrate the currents between any paralleled MOSFETs. This can be done by design of the printed circuit board, which is drawn symmetrically.

## Claims

1. A relay (100), configured to be connected between a voltage source (110) and a pre-heater (120) to be driven, comprising:
- a high stage (HS),
- a low stage (LS),
- an intermediate stage (IS), and
- a microcontroller (U4),
wherein, the high stage (HS), the low stage (LS) and the intermediate stage (IS) are connected in series,
wherein, the high stage (HS) comprises
- a plurality of parallel MOSFETs (TR11, TR12), called high MOSFETs, having their drain electrodes connected to the voltage source (110), their source connected to the intermediate stage (IS) and their gate electrodes configured to be connected to the microcontroller (U4),
wherein the intermediate stage (IS) comprises
- a plurality of parallel intermediate MOSFET (TR13, TR14), called intermediate MOSFETs, having their drain electrodes connected to the low stage (LS), their source connected to the high stage (HS) and their gate electrode configured to be connected to the microcontroller (U4),
wherein, the low stage (LS) comprises
- a plurality of parallel MOSFETs (TR21, TR22), called low MOSFETs, having their drain electrodes connected to the intermediate stage (IS), their source connected to the pre-heater (120) and their gate electrodes configured to be connected to the microcontroller (U4),
wherein, the body diodes of the high stage (HS) and the low stage (LS) are arranged in first direction while the body diodes of the intermediate stage (IS) are arranged in a second direction opposite to the first direction.

2. The relay (100) of claim 1, wherein the intermediate MOSFETs (TR13, TR14) serves as a reverse polarity protector.

3. The relay (100) of any one of claims 1 or 2, further comprising a plurality of current measurement means (CM1, CM2) so arranged for measuring the current flowing through the intermediate MOSFETs (TR13, TR14),
each current measurement means (CM1, CM2) being configured for measuring a voltage between the drain electrode and the source of an intermediate MOSFET (TR13, TR14).

4. The relay (100) of claim **3,** wherein the voltage measurement means (CM1, CM2) comprises an operational amplifier whose entries are connected such that one pin (Vm) is connected to the drain electrode of the intermediate MOSFET (TR13, TR14) and another pin (Vp) is connected to the source of the intermediate MOSFET (TR13, TR14).

5. The relay (100) of any one of claims **3** or **4,** further comprising a protection device so arranged for protecting the pre-heater relay (100) against a short-circuit to ground, the protection device comprising means for inhibiting the high MOSFETs (TR11, TR12) and/or the low MOSFETs (TR21, TR22), when triggered by the current measurement means (CM1, CM2).

6. The relay (100) of claim **5,** wherein the means for inhibiting the high MOSFETs (TR11, TR12) and/or the low MOSFETs (TR21, TR22), connect the gate electrode(s) of the corresponding MOSFETs (TR11, TR12, TR21, TR22) to the ground by means of a transistor whose base is connected to the output of the protection device.

7. The relay (100) of any one of claims **5** or **6,** wherein the means for inhibiting the at least one high MOSFET (TR11, TR12) and/or the at least one low MOSFET (TR21, TR22), is further latched by a latched circuit.

8. The relay (100) of any one of claims **1** to **7,** further comprising at least one charge pump-up device (PU1, PU2) which is configured to raise the voltage applied to the gate electrode(s) of the high MOSFET (TR11, TR12), and/or the intermediate MOSFET (TR13, TR14) and/or the gate electrode(s) of the low MOSFET (TR21, TR22).

9. The relay (100) of any one of claims **1** to **8,** wherein tracks connecting at least the high MOSFETs (TR11, TR12) and low MOSFETs are designed with the same lengths to equilibrate the currents between any paralleled MOSFETs (TR21, TR22).
